# EUROPÄISCHE PATENTSCHRIFT

(11) **EP 2 399 440 B1**
(45) Veröffentlichungstag und Bekanntmachung des Hinweises auf die Patenterteilung: **19.11.2014**
(21) Anmeldenummer: 10706510.4
(22) Anmeldetag: 17.02.2010
(51) Int. Cl.: H05K 7/14, G06K 17/00

(54) **SCHALTSCHRANK ODER RACK**
SWITCHGEAR CABINET OR RACK
ARMOIRE DE COMMANDE OU BAIE

(30) Priorität: 19.02.2009 DE 102009009636
(43) Veröffentlichungstag der Anmeldung: 28.12.2011
(73) Patentinhaber: Rittal GmbH & Co. KG, 35745 Herborn (DE)
(72) Erfinder: THIELMANN, Bodo, 35768 Siegbach (DE); HAIN, Markus, 35684 Dillenburg (DE); SCHMIDT, Volker, 57076 Siegen (DE)
(74) Vertreter: Tönhardt, Marion
(86) Internationale Anmeldenummer: PCT/EP2010/000978
(87) Internationale Veröffentlichungsnummer: WO 2010/094457

(56) Entgegenhaltungen:
- WO-A1-2009/058233
- DE-A1-102007 034 437
- US-A1- 2006 171 538
- US-A1- 2008 265 722

## Beschreibung

Die Erfindung bezieht sich auf einen Schaltschrank oder ein Rack mit einer Montageeinrichtung, die einen Einbauraum für anwenderseitige Einbaueinheiten frontseitig seitlich begrenzende vertikale Montageprofile mit in einer frontseitigen Montageebene liegenden flachen Befestigungsabschnitten zum Anschlagen von seitlich abstehenden Montageabschnitten der Einbaueinheiten aufweist, und mit Komponenten einer Erfassungseinrichtung zum Feststellen, ob an einer Einbauposition des Einbauraums eine Einbaueinheit vorhanden ist oder nicht, wobei die Komponenten der Erfassungseinrichtung eine an einem Montageprofil angebrachte vertikal verlaufende Antennenleiste, die mit ihrer Rückseite in Anlage an einen Anlageabschnitt des Montageprofils gebracht ist, mit darin angeordneten Antennenelementen und an den Einbaueinheiten angeordneten, als Transponderelemente ausgebildeten Code-Trägern aufweisen.

Ein derartiger Schaltschrank bzw. derartiges Rack ist in der DE 10 2007 034 437 A1 angegeben. Bei diesem bekannten Schaltschrank ist eine Vorrichtung zum Erkennen von darin aufgenommenen Einbaueinheiten mit einer Erfassungseinheit ausgerüstet, die an eine Auswerteoder Registriereinrichtung angeschlossen oder anschließbar ist. Die Erfassungseinheit weist dabei in einer Ausgestaltung eine in der Montage- ebene der Einbaueinheiten angeordnete, an einem Rahmenschenkel oder Montageteil angeschraubte oder aufgeklebte Detektorleiste mit im Raster von einer oder mehreren Höheneinheiten positionierten, berührungslos ansprechenden Antennenelementen und an den Einbaueinheiten angeordnete Transponder, insbesondere RFID- Tags auf. Die leistenförmige Antennenanordnung kann sich dabei aus mehreren mit Stecker-/Kupplungseinheiten zusammengesteckten Antennenmodulen zusammensetzen, die jeweils ein schmales, sich längs erstreckendes, leistenartiges Kunststoffgehäuse zur Abdeckung mehrerer Höheneinheiten aufweisen. Das Gehäuse, das sich auch über die gesamte Höhe des Aufnahmebereichs für die Einbaueinheiten erstrecken kann, besitzt Befestigungsmöglichkeiten zum Anbringen z. B. an einer vertikalen Montageschiene, an der auch die Einbaueinheiten festgelegt sind. Die Transponder bzw. RFID-Tags sind im vorderen Bereich der Einbaueinheiten, insbesondere Servereinheiten, an deren Gehäuse nahe der Detektorleiste positioniert, so dass die Antennenelemente im Nahfeld der jeweils zugeordneten Transponder deren Information auslesen, die über eine Datenleitung oder alternativ drahtlos zu der Auswerte- und Registriereinrichtung übertragen wird. Das jeweilige RFID-Tag besitzt eine eindeutige Identifikation und kennzeichnet die zu erfassende Einbaueinheit, die über die betreffenden Antennenelemente unter Steuerung durch eine Steuereinheit ausgelesen und mit der zugehörigen Höhenposition an die Auswerteeinheit übermittelt wird. Die Befestigung der RFID-Tags an der Einbaueinheit erfolgt durch Kleben oder Schrauben. Die eindeutige Identifikation des so aufgebauten passiven Transponders bzw. RFID-Tags erfolgt bereits im Herstellungswerk.

Ein Schaltschrank oder Rack der eingangs genannten Gattung ist außerdem aus der US 2008/265722 A1 bekannt.

Zwar ergibt die Anordnung der Detektorleiste im Bereich der Einbauebene des Schaltschranks oder Racks vorteilhafte Montagemöglichkeiten und eine günstige Signalerfassung in Verbindung mit den Transpondern. Jedoch kann es durch ungenaue Montage zu Störungen in der Signalerfassung und Signalübertragung und da- mit unzuverlässiger Positionserfassung oder Zuordnung von Identifikationen kommen.

Die US 2006/71538 A1 offenbart eine Konfiguration, bei der eine an einer Tür eines Racks montierte Antennenleiste bei geschlossener Tür mit Transpondern, die an sich in dem Rack befindenden Einbaugeräten angebracht sind, in Überlappung gebracht werden kann.

Der Erfindung liegt die Aufgabe zugrunde, einen Schaltschrank oder Rack der eingangs genannten Art bereitzustellen, bei dem eine ungenaue oder fehlerhafte Montage der Erfassungseinrichtung möglichst ausgeschlossen wird.

Diese Aufgabe wird mit den Merkmalen des Anspruches 1 gelöst. Hierbei ist vorgesehen, dass die Antennenleiste mit ihrer Frontseite in der Montageebene liegt oder gegenüber dieser um höchstens 10 mm zurückversetzt ist und dass das jeweilige Transponderelement vor der Frontseite der Antennenleiste angeordnet und auf einem die Antennenleiste überlappenden Tragabschnitt eines Halteelementes befestigt ist, das mit einem Verbindungsabschnitt an dem benachbarten Montageabschnitt der zugeordneten Einbaueinheit angebracht ist.

Mit diesen Maßnahmen werden eine eindeutige, genaue Montage der Antennenleiste und der Transponderelemente und eine exakte Zuordnung der Transponderelemente zu in der Antennenleiste vorhandenen Antennenelementen sichergestellt.

Eine eindeutige, exakte Montage der Antennenleiste wird dadurch begünstigt, dass das Montageprofil eine an den Querschnitt der Antennenleiste zumindest teilweise angepasste Aufnahme mit einem gegenüber der Montageebene zumindest um die Querschnittstiefe der Antennenleiste zurückversetzten Anlageabschnitt und mit einer die Aufnahme auf deren dem Einbauraum zugekehrter Seite begrenzenden innenseitigen Begrenzungswand aufweist.

Ferner tragen die Maßnahmen, dass der Anlageabschnitt und die innenseitige Begrenzungswand im Querschnitt der Aufnahme rechtwinklig zueinander angeordnet sind, wobei der Anlageabschnitt parallel zur Montageebene ausgerichtet ist, zu einer eindeutigen Einbaulage der Antennenleiste bei.

Dabei ist die Ausgestaltung von Vorteil, dass die Begrenzungswand rechtwinklig in den Befestigungsabschnitt übergeht.

Eine vorteilhafte Ausgestaltung für die Anordnung der Erfassungseinrichtung und den Aufbau des Montageprofils besteht darin, dass der Anlageabschnitt rechtwinklig in einen bezüglich der Montageebene nach hinten gerichteten Seitenwandabschnitt übergeht oder rechtwinklig in eine nach vorn zur Montageebene gerichteten und höchstens bis in diese vorstehende außenseitige Begrenzungswand der Aufnahme übergeht.

Die Installation der Antennenleiste wird dadurch begünstigt, dass in dem Anlageabschnitt eine Haltelochreihe mit in regelmäßigem Rasterabstand angeordneten Haltelöchern angeordnet ist.

Weitere Vorteile für die Montage der Antennenleiste ergeben sich dadurch, dass die Haltelöcher quadratisch oder rechteckförmig mit parallel zur Längsrichtung des Montageprofils verlaufenden Längsseiten ausgebildet sind und dass die Antennenleiste auf ihrer dem Anlageabschnitt zugekehrten Rückseite mit Haltehaken versehen ist, die auf den Abstand der Haltelöcher oder ein Vielfaches davon abgestimmt sind und vertikale Hakenabschnitte aufweisen, die eine geringere Länge besitzen als die lichte Öffnungsweite der Haltelöcher in vertikaler Richtung und die soweit von der rückseitigen Außenfläche der Antennenleiste beabstandet sind, dass sie einen die Haltelöcher umgebenden Wandbereich des Anlageabschnitts mit einer gewissen Klemmkraft hintergreifen.

Ein vorteilhafter Aufbau der Antennenleiste besteht darin, dass die Antennenleiste quadratischen oder rechteckförmigen Querschnitt besitzt und bezüglich der eingebauten Lage auf ihrer Frontseite mit einem daran fest oder abnehmbar fixierten Abdeckteil versehen ist.

Ein Erkennen der Einbaulage mit der Möglichkeit einer Fehlersignalisierung bezüglich fehlerhafter Anordnung oder fehlerhafter Funktion der betreffenden Einbaueinheiten wird dadurch erhalten, dass das Abdeckteil zumindest abschnittsweise transparent ausgebildet ist und dass im Inneren der Antennenleiste Leuchtelemente angeordnet sind, die in Längsrichtung der Antennenleiste in gleichmäßigem Rasterabstand im Raster einer Höheneinheit HE oder einem ganzzahligen Vielfachen oder gleichmäßigen Teilabstand davon angeordnet, getrennt ansteuerbar und im Leuchtzustand durch das transparente Abdeckteil positionsgenau sichtbar sind.

Eine genaue Positionserfassung wird dadurch begünstigt, dass im Inneren der Antennenleiste im Raster einer Höheneinheit HE oder einem ganzzahligen Vielfachen oder gleichmäßigen Teilabstand davon in Längsrichtung der Antenneneinheit voneinander beabstandete Antennenelemente angeordnet sind.

Die Montage der Einbaueinheiten und eine genaue Zuordnung zu der Antennenleiste werden dadurch begünstigt, dass in den Befestigungsabschnitten Lochreihen mit in vertikaler Richtung im Rasterabstand einer Höheneinheit HE oder einem gleichmäßigen Teilabstand davon beabstandeten Löchern angeordnet sind, dass in den Montageabschnitten der Einbaueinheiten auf den Abstand der Befestigungslöcher oder ein ganzzahliges Vielfaches davon abgestimmte Montagelöcher angeordnet sind und dass in den Befestigungsabschnitten der Halteelemente auf die Montagelöcher abgestimmte Öffnungen angeordnet sind, wobei der Abstand von der Mitte der Befestigungslöcher bis zum außenseitigen Rand der Antennenleiste so groß ist wie die Ausdehnung der Halteelemente von der Mitte der Öffnungen zum äußeren Rand des Trageabschnitts.

Ferner tragen zu einer vorteilhaften Montage der Antennenleiste die Maßnahmen bei, dass die vertikalen Montageprofile sich zwischen einem oberen und unteren horizontalen Montageschenkel oder Rahmenschenkel des Schaltschranks oder Racks erstrecken und dass in Verlängerung der Antennenleiste in ihrer Einbaulage in dem oberen und/oder unteren horizontalen Montageschenkel oder Rahmenschenkel eine Ausdehnung eingebracht ist, die größer ist als der Querschnitt der Antennenleiste.

Die Erfindung wird nachfolgend anhand von Ausführungsbeispielen unter Bezugnahme auf die Zeichnungen näher erläutert. Es zeigen:
- Fig. 1: eine frontseitige Montageebene eines Schaltschranks oder Racks,
- Fig. 2: einen Ausschnitt eines Einbauraums eines Schaltschranks oder Racks mit vorderer Montageebene und vertikalen Montageprofilen in perspektivischer Ansicht,
- Fig. 3: einen Ausschnitt der Montageebene im Bereich eines Montageabschnittes,
- Fig. 4: eine Detailansicht des Schaltschranks oder Racks in einem oberen vorderen Eckbereich des Einbauraums und der Montageebene mit mehreren eingesetzten Einbaueinheiten,
- Fig. 5: einen Ausschnitt des Schaltschranks oder Racks in einem oberen vorderen Eckbereich mit einer eingesetzten Antennenleiste und einem Halteelement mit Transponder in perspektivischer Ansicht,
- Fig. 6: einen Ausschnitt der Befestigungsebene im Bereich eines Montageabschnittes mit vertikalem Montageprofil, eingesetzter Antennenleiste und angebrachtem Halteelement mit Transponder,

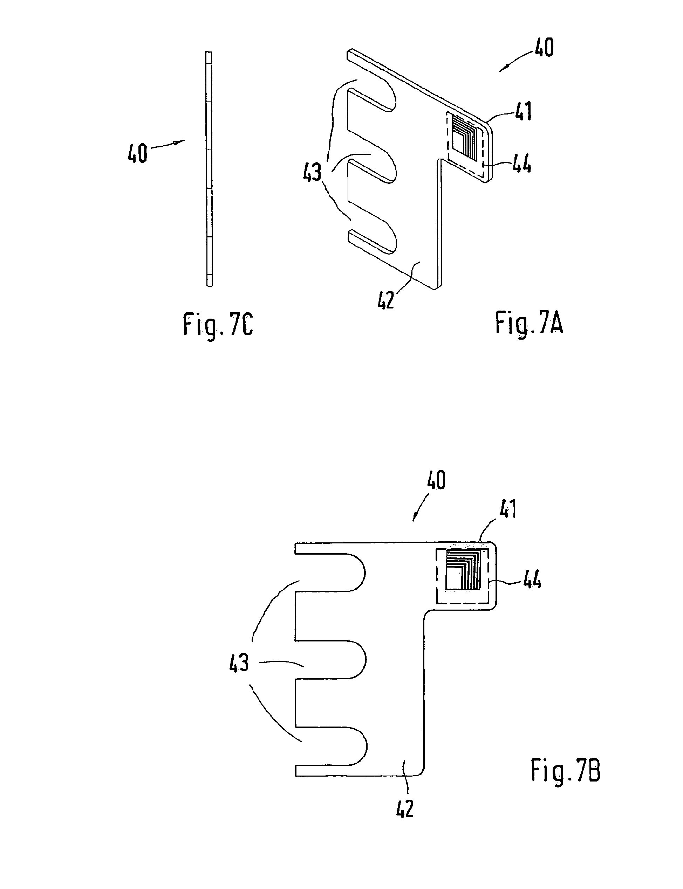

- Fig. 7A bis 7C: eine perspektivische Ansicht, eine Vorderansicht und eine Ansicht auf die rückseitige Stirnseite eines Halteelementes mit Transponderelement,
- Fig. 8: eine perspektivische Ausschnittdarstellung des vorderen oberen Eckbereichs des Schaltschranks oder Racks mit einer Antennenleiste vor deren Einbau,
- Fig. 9A bis 9D: in Fig. 9A eine perspektivische Ansicht eines Abschnitts der Antennenleiste schräg auf die Rückseite; in den Teilbildern a), b) und c) der Fig. 9B die Antennenleiste von der Vorderseite, in einer seitlichen Ansicht und von der Rückseite; in Fig. 9C einen Längsschnitt der Antennenleiste sowie in Fig. 9D einen Querschnitt der Antennenleiste,
- Fig. 10: verschiedene Ansichten des vorderen Montagerahmens des Schaltschranks oder Racks mit seitlichen vertikalen Montageprofilen und einem unteren und oberen Rahmenschenkel sowie vergrößerten Ausschnittdarstellungen,
- Fig. 11: den vorderen Montagerahmen des Schaltschranks oder Racks in perspektivischer Ansicht,
- Fig. 12: einen Ausschnitt des Montagerahmens nach Fig. 11 im Verbindungsbereich zweier auseinander geschobener Leistenmodule und
- Fig. 13: ein Beispiel für eine Bildschirmdarstellung einer Einbauebene eines Schaltschranks oder Racks mit eingesetzten Einbaueinheiten in Form von Servereinheiten.

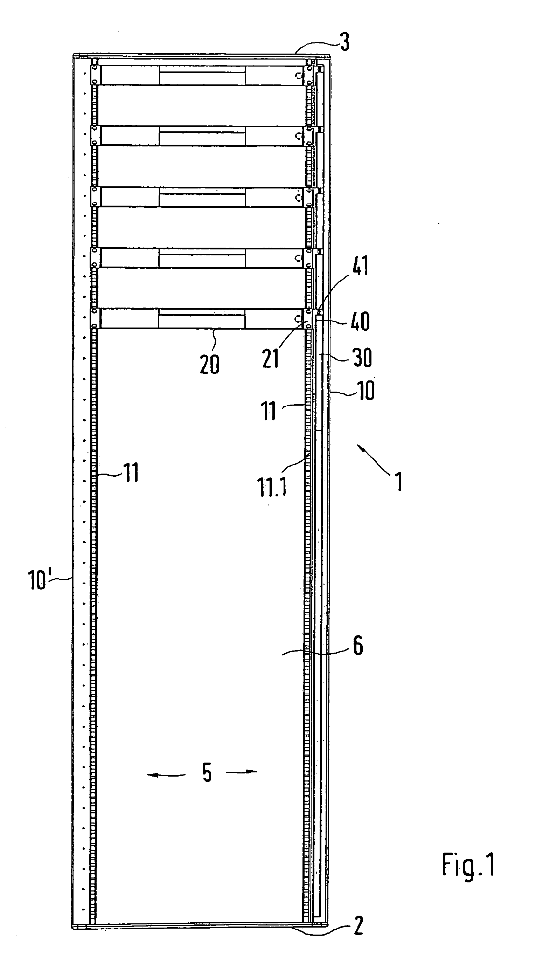

Fig. 1 zeigt eine vorderseitige Ansicht einer Montageebene 5 eines Rahmengestells 1 eines Schaltschranks oder Racks mit mehreren eingebauten Einbaueinheiten 20, wie z. B. Servereinheiten, deren Höhe beispielsweise eine HE beträgt. Die Montageebene 5 ist seitlich durch frontseitige Montageflächen zweier vertikaler Montageprofile 10, 10' und unten von einem unteren Rahmenschenkel 2 sowie oben von einem oberen Rahmenschenkel 3 begrenzt. An den die lichte Einbauöffnung begrenzenden Ränder der Montageprofile 10, 10' schließen sich beidseitig Befestigungsabschnitte 11 der Montageprofile mit Lochreihen 11.1 an, die einen engen Lochrasterabstand von vorliegend drei Befestigungslöchern pro Höheneinheit HE besitzen. Die Montageprofile 10, 10' können durch seitliche Rahmenprofile des Rahmengestells und/oder durch separate Montageprofile gebildet sein.

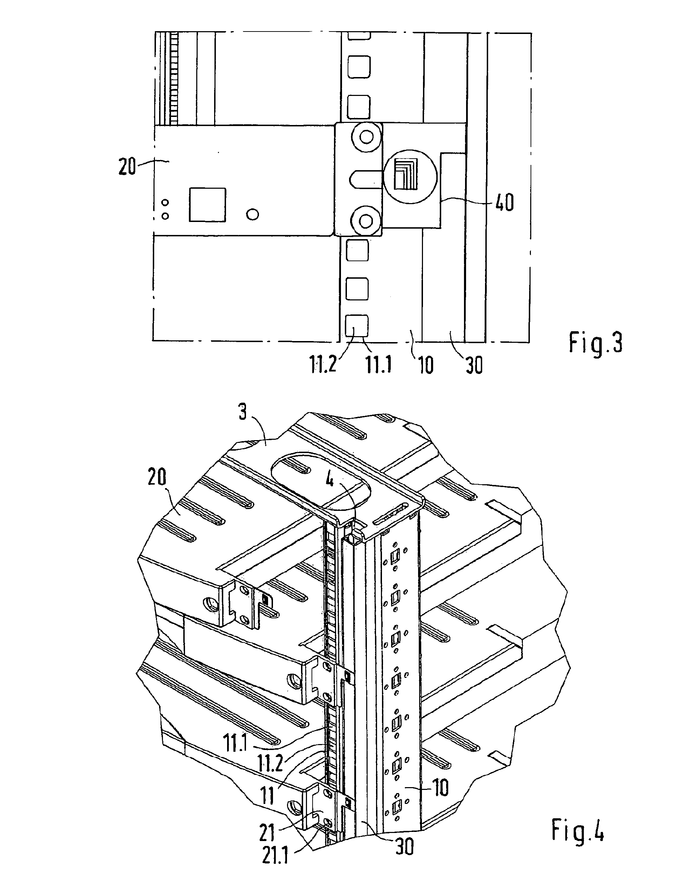

Die Einbaueinheiten 20 weisen seitlich abstehende flache Montageabschnitte 21 auf, die sich über die Gehäusehöhe der Einbaueinheiten 20 erstrecken und über die beiderseitigen Befestigungsabschnitte 11 vorstehen. In den Montageabschnitten 21 sind z. B. jeweils zwei Montagelöcher 21.1 (vgl. z. B. auch Fig. 4) vorliegend im doppelten Abstand der Befestigungslöcher 11.2 der Lochreihe 11.1 eingebracht, so dass die Montagelöcher 21.1 jeweils ein Befestigungsloch 11.2 überspringen.

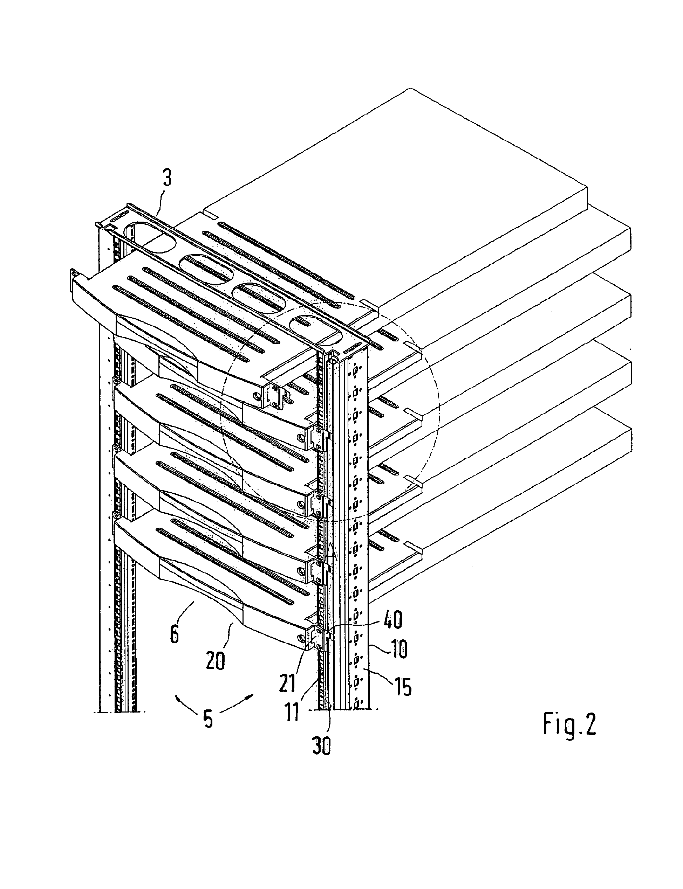

Im Bereich eines seitlichen Montageabschnittes, vorliegend des in Vorderansicht rechten Montageabschnittes 21, sind jeweils Halteelemente 40 angeordnet, beispielsweise an dem Montageabschnitt 21 festgeklebt oder zumindest zwischen diesem und dem Befestigungsabschnitt 11 eingeklemmt, wobei ein zungenartiger Tragabschnitt 41 seitlich absteht und eine in dem Montageprofil 10 eingesetzte Antennenleiste 30 frontseitig überlappt, wie der Ausschnittsdarstellung nach Fig. 2 und den weiteren Darstellungen nach den Fig. 3, 4 und 5 deutlicher zu entnehmen ist.

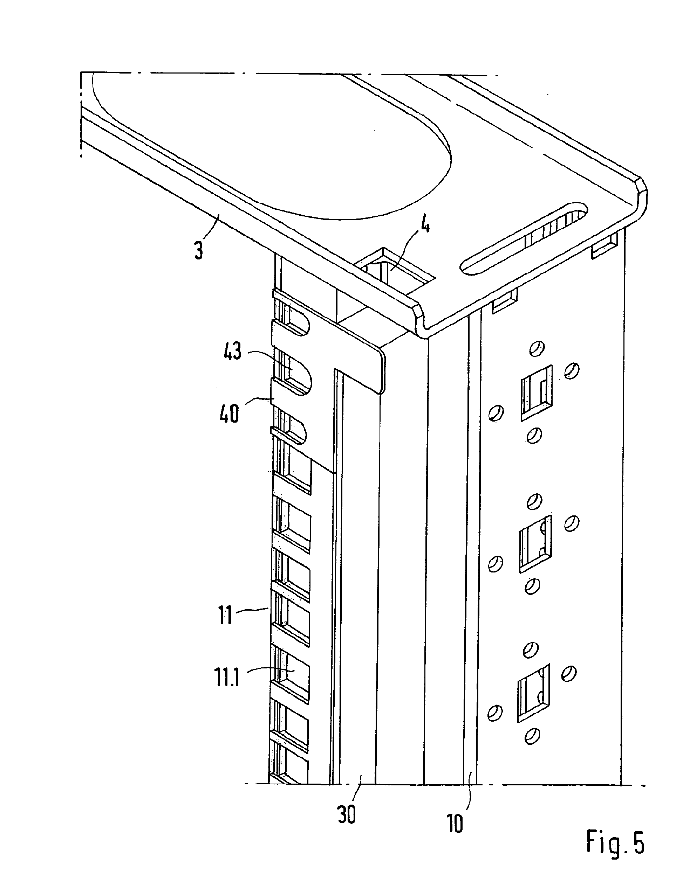

Wie Fig. 2 in perspektivischer Darstellung zeigt, sind die Halteelemente 40, die aus flachem blättchenförmigem Material beispielsweise aus Metall oder Kunststoff hergestellt sind, mit einem Verbindungsabschnitt 42 zwischen der flachen Rückseite des betreffenden Montageabschnittes 21 und der flachen Vorderseite des Befestigungsabschnittes 11 festgespannt, wobei sie zuvor vorteilhaft an dem Montageabschnitt 21 fixiert wurden, beispielsweise mittels einer auf ihnen angebrachten Klebeschicht, die im nicht angebrachten Zustand von einer ablösbaren Schutzfolie abgedeckt ist. In dem Verbindungsabschnitt 42 sind an die Montagelöcher 21.1 in Lage und Größe abgestimmte Öffnungen 43 eingebracht, so dass die in den Einbauraum 6 eingesetzten und mit ihren Montageabschnitten 21 an den Befestigungsabschnitten 11 anliegenden Einbaueinheiten 20 mittels Schrauben ungehindert an den Befestigungsabschnitten 11 befestigt werden können, wie Fig. 3 zeigt. Wie ferner aus Fig. 5 ersichtlich, sind dabei auch die Öffnungen 43 mit den betreffenden Befestigungslöchern 11.2 der Lochreihen 11.1 in Deckung gebracht.

Wie die Fig. 2 und insbesondere die vergrößerte Ausschnittsdarstellung nach Fig. 4 sowie auch die Fig. 5, 6 und 8 weiter zeigen, ist zumindest das in Draufsicht rechte Montageprofil, dem die Antennenleiste 30 zugeordnet ist, zur Außenseite an den betreffenden Befestigungsabschnitt 11 anschließend mit einer innenseitigen Begrenzungswand 13 einer Aufnahme 14 für die Antennenleiste 30 versehen. Die innenseitige Begrenzungswand 13 geht an ihrem von der Frontseite abliegenden rückseitigen Ende rechtwinklig in einen nach außen zeigenden Anlageabschnitt 12 in der Tiefe der Aufnahme 14 über, an die die Antennenleiste 30 beim Einsetzen in Anlage gebracht wird. Dabei ist die Vorderseite des Anlageabschnittes 12 von der frontseitigen Montageebene bzw. der Ebene des Befestigungsabschnittes 11 in einem solchen Abstand zurück versetzt, dass die Antennenleiste 30 mit ihrer Vorderseite nicht über die Frontebene des Befestigungsabschnittes 11 übersteht und vorzugsweise mit dieser bündig ist oder nur wenig zurückversetzt ist. Besonders bei bündiger Anordnung der Vorderseite der Antennenleiste 30 in der vorderen Montageebene ist der Tragabschnitt 41, auf dessen Rückseite ein insbesondere als RFID-Tag ausgebildetes Transponderelement 44 angebracht ist und der die Frontseite der Antennenleiste 30 überlappt, in möglichst geringem Abstand zur Antennenleiste 30 und darin enthaltenen Antennenelementen angeordnet, so dass sich eine geringe Übertragungsdistanz für die Informationsübertragung zwischen Transponderelement 44 und dem betreffenden Antennenelement ergibt.

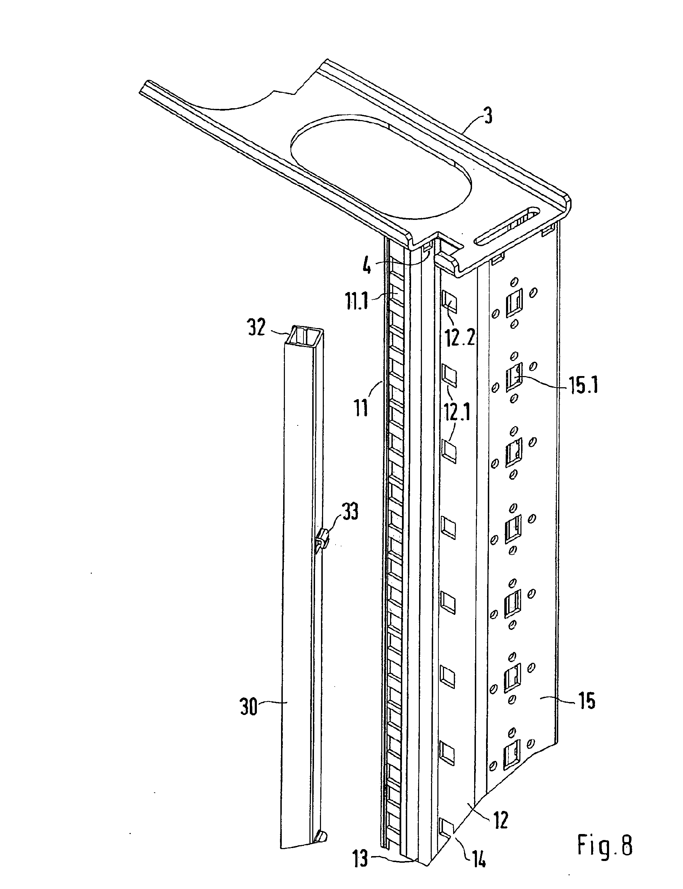

Wie aus Fig. 8 weiter ersichtlich, ist in dem Anlageabschnitt 12 eine Haltelochreihe 12.1 mit mindestens zwei Haltelöchern 12.2 eingebracht, die einen gleichmäßigen Lochrasterabstand in vertikaler Richtung aufweisen, beispielsweise im Abstand einer oder mehrerer Höheneinheiten. Die Haltelöcher 12.2 sind rechteckförmig oder quadratisch geformt und mit ihren Lochbegrenzungsseiten horizontal bzw. vertikal bezüglich der Längsrichtung des Montageprofils 10 bzw. 10' ausgerichtet. Die Antennenleiste 30 ist auf ihrer Rückseite mit Hakenelementen 33 versehen, die beispielsweise durch teilweises Ausstanzen und Ausbiegen aus deren Rückwand hergestellt sind, wobei nach unten gerichtete Hakennasen gebildet sind, die von der Rückwandebene der Antennenleiste 30 um etwas weniger als die Stärke der Wandung des Anlageabschnittes 12 um die Haltelöcher 12.2 beabstandet sind, wobei der nach unten gerichtete Abschnitt an seinem unteren Endabschnitt nach außen von der Rückwandebene der Antennenleiste 30 weggebogen ist, so dass sich ein einfaches Einhängen ergibt. Der nach unten gerichtete Hakenabschnitt ist dabei kürzer als die vertikale Öffnungsweite der Haltelöcher 12.2. Über die Länge der Antennenleiste 30 sind mehrere derartige Hakenelemente angeordnet, die auf den Lochrasterabstand der Haltelöcher 12.2 oder ein Mehrfaches davon abgestimmt sind. Außerdem ist die Breite der Haken auf die Breite der Haltelöcher 12.2 derart abgestimmt, dass sie mit möglichst geringem seitlichem Spiel in die Haltelöcher 12.2 passen. Mit diesen Maßnahmen kann die Antennenleiste 30 einfach und lagegenau in die Aufnahme 14 eingesetzt und mit ihrer Rückseite in Anlage an die Vorderseite des Anlageabschnittes 12 gebracht und anschließend durch Verschieben nach unten fixiert werden, wobei die Haltehaken 33 eine leichte Klemmwirkung ergeben.

Wie Fig. 8 weiter zeigt, ist in dem oberen horizontalen Rahmenschenkel 3, der auch ein Montageschenkel sein kann, fluchtend bezüglich der eingesetzten Antennenleiste 30 eine Ausnehmung 4 eingebracht, die mindestens so groß ist wie der Außenquerschnitt der Antennenleiste 30, so dass diese auch dann ungehindert eingesetzt werden kann, wenn sie sich im eingesetzten Zustand bis in den Bereich des oberen Endes der vertikalen Montageprofils 10 bzw. 10' erstreckt, um auch die obere Einbauposition des Einbauraums 6 auszunutzen. Auf diese Weise kann die Antennenleiste 30 über das vertikale Rahmenprofil 10 bzw. 10' hinausstehend eingesetzt und dann nach unten verschoben werden, um sie zu fixieren.

Wie die Fig. 2, 4, 5 und 8 weiter zeigen, geht der Anlageabschnitt 12 an seinem außenseitigen Rand in einen außenseitigen Seitenwandabschnitt 15 des Montageprofils 10 bzw. 10' über, der nach hinten gerichtet ist, und in dem eine weitere vertikale Lochreihe 15.1 mit Löchern für Montagezwecke angeordnet ist. Die Aufnahme 14 könnte auch auf ihrer Außenseite mit einer weiteren Wand parallel zur innenseitigen Begrenzungswand 13 versehen sein, die mit ihrem vorderen Rand höchstens bis in die frontseitige Montageebene vorsteht.

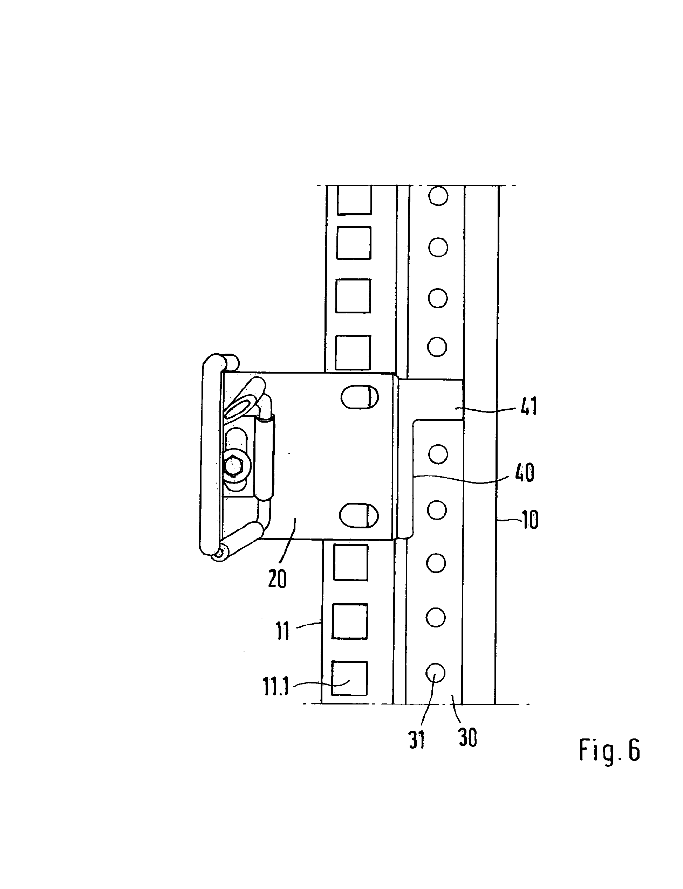

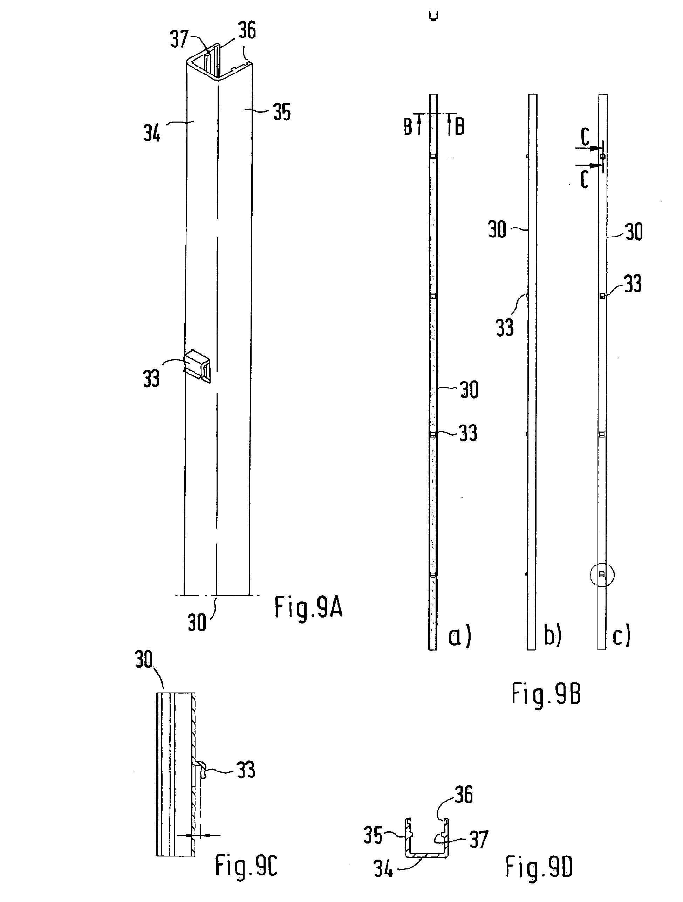

Wie Fig. 8 und weiterhin die Fig. 9A bis 9D zeigen, besitzt die Antennenleiste 30 ein Gehäuse mit U-förmigem, z. B. quadratischem oder rechtförmigem Querschnitt mit einem Basisschenkel 34 und zwei Seitenschenkeln 35. In die im eingebauten Zustand zur Frontseite des Schaltschranks bzw. Racks gerichtete vordere Seite ist ein Abdeckteil 32 eingesetzt, beispielsweise eingeschnappt oder eingerastet. Zum Halten des Abdeckteils 32 sind auf der Innenseite der Seitenschenkel 35 in der Nähe des freien Randes derselben längs verlaufende Haltenuten 36 ausgebildet, die die freien Ränder des vorzugsweise flachen Abdeckteils 32 vorderseitig und rückseitig überfassen. Das Abdeckteil 32 kann auch oder zusätzlich eingeklebt werden. Außerdem sind, gegenüber den Haltenuten 36 tiefer nach innen versetzt, auf der Innenseite der Seitenschenkel 35 sich gegenüberliegende Halterippen 37 eingebracht, so dass im Inneren des U-förmigen Gehäuses der Antennenleiste 30 weitere Elemente beispielsweise mittels Halteplättchen fixiert werden können, wie z. B. die genannten Antennenelemente und Zuführleitungen sowie auch später noch beschriebene Leuchtelemente 31 (vgl. Fig. 6). Das Abdeckteil 32 ist vorzugsweise lichtdurchlässig durchscheinend bzw. transparent ausgebildet, so dass Licht der Leuchtelemente 31 durchtritt, wobei die Leuchtelemente klar umgrenzt in ihrer Position erkennbar sind, jedoch der Innenraum der Antennenleiste 30 vorzugsweise nicht einsehbar ist. Hierzu eignet sich entsprechend eingetrübtes Glas mit möglichst geringer Lichtschwächung und z. B. ohne selektive spektrale Filtereigenschaften.

Wie Fig. 6 zeigt, sind die Leuchtelemente 31 ebenfalls in einem gleichmäßigen Rasterabstand über die Länge der Antennenleiste 30 angeordnet, wobei z. B. drei Leuchtelemente 31 pro Höheneinheit HE eingesetzt sind. Zwei der Leuchtelemente 31 liegen dabei neben dem Montageabschnitt 21 bzw. Verbindungsabschnitt 42 des Halteelementes 40 frei, und befinden sich bei eingesetzter Einbaueinheit 20 im angesteuerten leuchtenden Zustand, während ein drittes Leuchtelement 31 pro Höheneinheit bei eingesetzter Einbaueinheit 20 von dem Tragabschnitt 41 des Halteelementes 40 abgedeckt ist, das sich in vertikaler Richtung nur über ein Drittel einer Höheneinheit HE erstreckt. Auf diese Weise werden einem Betrachter die Einbaulagen auch visuell gut erkennbar angezeigt, wobei besetzte Einbaupositionen leicht wahrnehmbar sind. Die Leuchtelemente 31 können über (eine nicht gezeigte) Steuereinheit, wie sie beispielsweise in der eingangs genannten DE 10 2007 034 437 A1 angegeben ist, angesteuert werden, wobei verschiedene Ansteuerungsweisen in Frage kommen, z. B. in verschiedenen Farben unter Einsatz von verschiedenfarbig betreibbaren Leuchtdioden, oder in verschiedenen Blinkmodi bzw. im Dauerlichtbetrieb. Die Leuchtelemente 31 werden dabei in Abhängigkeit von den von den Transponderelementen 44 erhaltenen und über die Antennenelemente an die Steuereinheit weitergeleiteten Informationen angesteuert. Die Antennenelemente können im selben Rasterabstand und in enger Nähe zu den Leuchtelementen 31 angeordnet sein, so dass sich eine eindeutige Informationserfassung und Positionszuordnung erreichen lässt. Weitere Signalisierungen können in Abhängigkeit von dem Betriebszustand der Einbaueinheiten, ihren in den Transponderelementen 44 z. B. werkseitig programmierten Eigenschaften und ihrer Einbaulage gesteuert werden, wobei die Steuereinheit auch mit einer übergeordneten Überwachungseinrichtung und Registrierungseinrichtungen zusammenarbeiten kann.

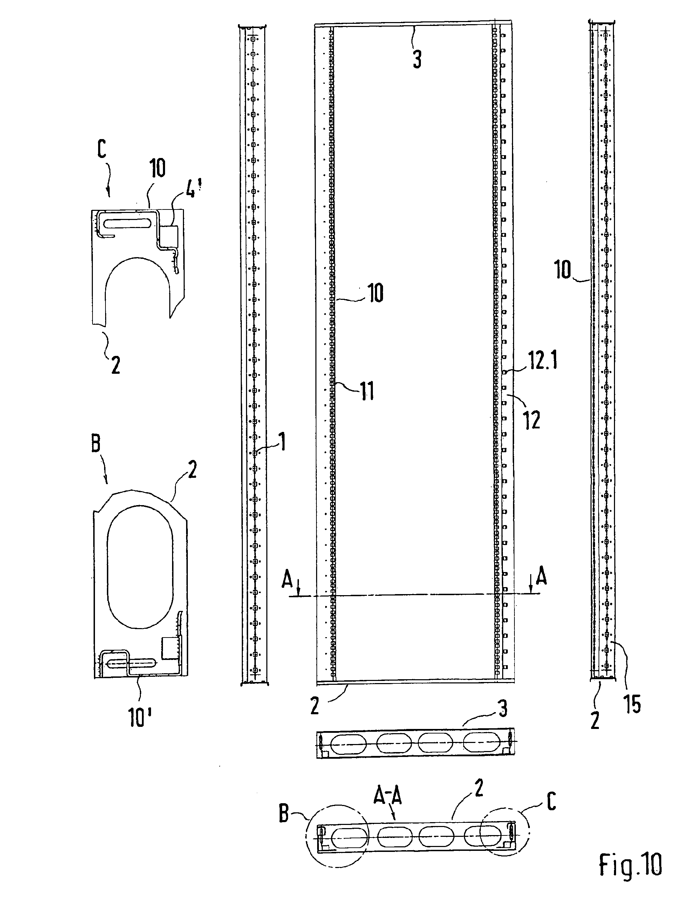

Wie Fig. 10 zeigt, kann auch in dem unteren Rahmenschenkel 2 eine Ausnehmung 4' zum Verschieben der Antennenleiste 30 nach unten eingebracht sein. Die beiden vertikalen Montageprofile 10, 10' können gleichen oder unterschiedlichen Aufbau aufweisen, wie die vergrößerten Ausschnitte B und C zeigen.

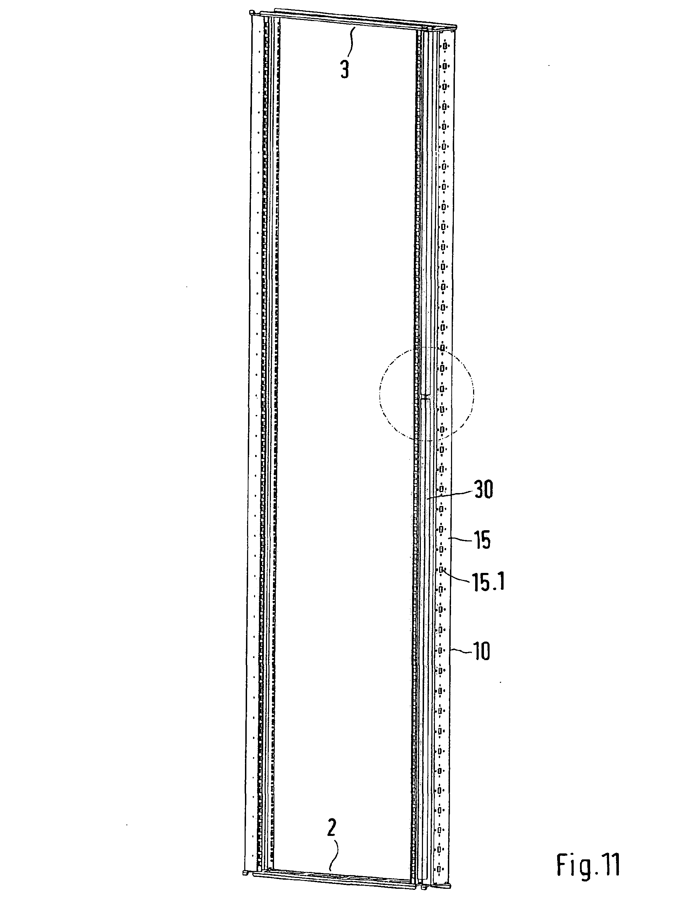

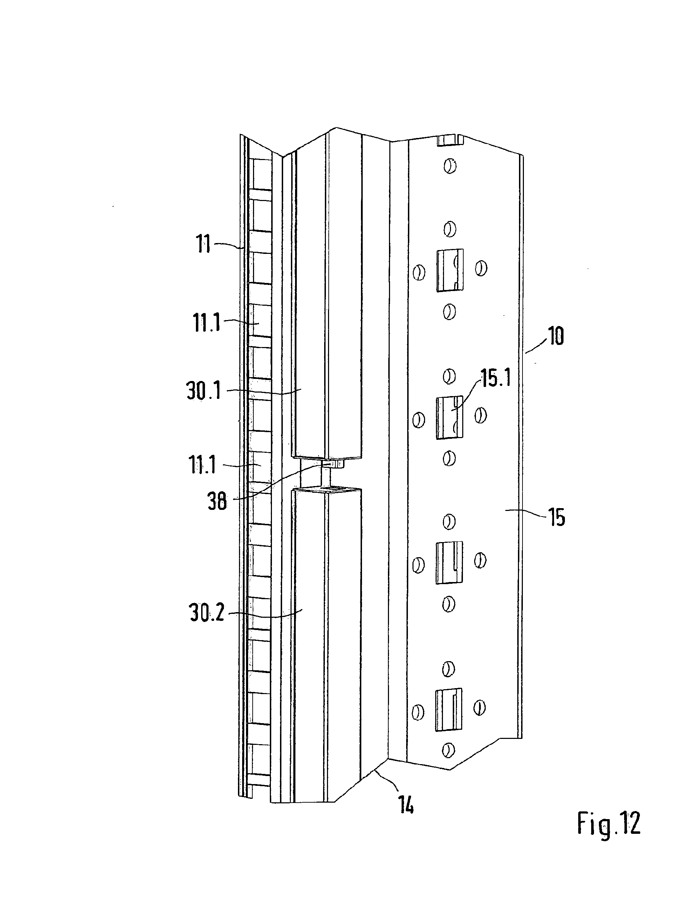

Wie die Fig. 11 und die vergrößerte Ausschnittdarstellung in Fig. 12 zeigen, kann die Antennenleiste 30 aus mehreren Leistenmodulen 30.1, 30.2 zusammengesetzt sein, die über eine Stecker-/Kupplungseinheit elektrisch leitend zusammengesteckt werden können, wobei sich auch eine mechanische Verbindung ergibt, die aber zusätzlich noch mittels Rastelementen oder anderen Steckelementen ergänzt sein kann. Die Leistenmodule 30.1, 30.2 erstrecken sich vorzugsweise über mehrere Höheneinheiten und besitzen eine Länge, die auf verschiedene gängige Schaltschrankhöhen abgestimmt ist, so dass das kleinste Modul in einen Schaltschrank niedrigster Höhe passt und eine Antennenleiste 30 für einen höheren Schaltschrank durch Zusammenstecken mehrerer Leistenmodule 30.1, 30.2 erhalten wird.

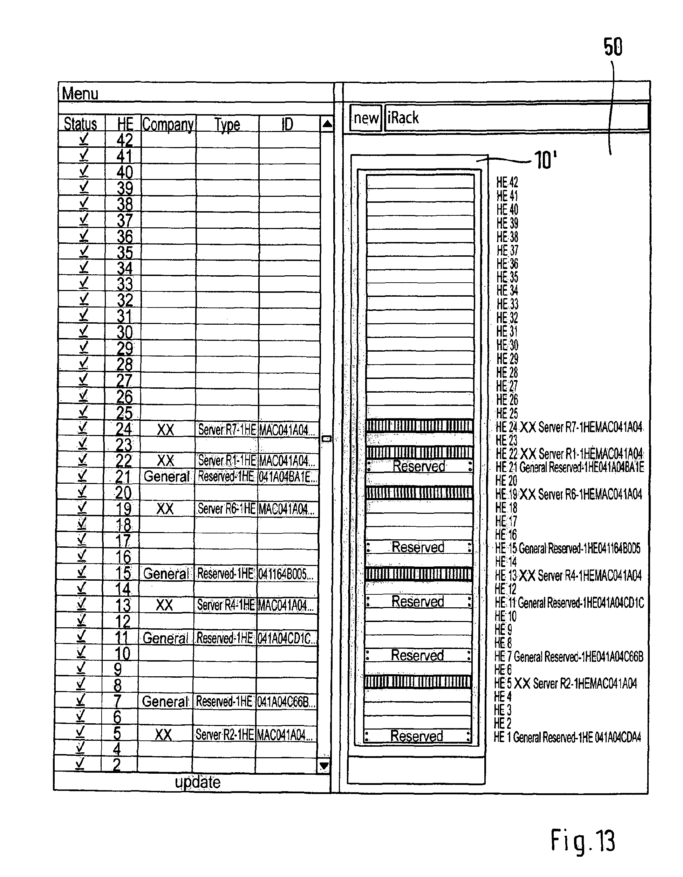

Fig. 13 zeigt ein Beispiel für eine Anzeige auf einem Sichtschirm einer entfernten Anzeigestation, wobei auf einer Bildschirmanzeige 50 die Montageebene eines Schaltschranks oder Racks mit seinen Höheneinheiten HE1 bis HE42 mit belegten Einbaupositionen dargestellt ist. Ferner sind neben der Einbauebene Zusatzinformationen zu den einzelnen Einbaueinheiten, beispielsweise Servereinheiten, eingeblendet, die den aktuellen Status und Eigenschaften der Einbaueinheiten 20 wiedergeben. Derartige Informationen können auf den Transponderelementen 44, insbesondere RFID-Tags, zum Teil gespeichert, zum anderen Teil erzeugt werden und über die Antennenelemente und die Steuereinheit weitergeleitet werden. Auch können die auf den RFID-Tags enthaltenen und an die Steuereinheit, Registriereinrichtung bzw. übergeordnete Überwachungseinrichtung weitergeleiteten Informationen mit dort gespeicherten weiteren Informationen zu den Einbaueinheiten 20, wie z. B. technischen Daten, ergänzt werden.

## Patentansprüche

1. Schaltschrank oder Rack mit einer Montageeinrichtung, die einen Einbauraum (6) für anwenderseitige Einbaueinheiten (20) frontseitig seitlich begrenzende vertikale Montageprofile (10, 10') mit in einer frontseitigen Montageebene (5) liegenden flachen Befestigungsabschnitten (11) zum Anschlagen von seitlich abstehenden Montageabschnitten (21) der Einbaueinheiten (20) aufweist, und mit Komponenten einer Erfassungseinrichtung zum Feststellen, ob an einer Einbauposition des Einbauraums (6) eine Einbaueinheit (20) vorhanden ist oder nicht, wobei die Komponenten der Erfassungseinrichtung eine an einem Montageprofil (20) angebrachte vertikal verlaufende Antennenleiste (30), die mit ihrer Rückseite in Anlage an einen Anlageabschnitt des Montageprofils (10,10') gebracht ist, mit darin angeordneten Antennenelementen und an den Einbaueinheiten (20) angeordneten, als Transponderelemente (44) ausgebildeten Code-Trägern aufweisen,
**dadurch gekennzeichnet,**
**dass** die Antennenleiste (30) mit ihrer Frontseite in der Montageebene (5) liegt oder gegenüber dieser um höchstens 10 mm zurückversetzt ist und dass das jeweilige Transponderelement (44) vor der Frontseite der Antennenleiste (30) angeordnet und auf einem die Antennen leiste (30) überlappenden Tragabschnitt (41) eines Halteelementes (40) befestigt ist, das mit einem Verbindungsabschnitt (42) an dem benachbarten Montageabschnitt (21) der zugeordneten Einbaueinheit (20) angebracht ist.

2. Schaltschrank oder Rack nach Anspruch 1,
**dadurch gekennzeichnet,**
**dass** das Montageprofil (10) eine an den Querschnitt der Antennenleiste (30) zumindest teilweise angepasste Aufnahme (14) mit einem gegenüber der Montageebene (5) zumindest um die Querschnittstiefe der Antennenleiste (30) zurückversetzten Anlageabschnitt (12) und mit einer die Aufnahme (14) auf deren dem Einbauraum (6) zugekehrter Seite begrenzenden innenseitigen Begrenzungswand (13) aufweist.

3. Schaltschrank oder Rack nach Anspruch 2,
**dadurch gekennzeichnet,**
**dass** der Anlageabschnitt (12) und die innenseitige Begrenzungswand 13 im Querschnitt der Aufnahme (14) rechtwinklig zueinander angeordnet sind, wobei der Anlageabschnitt (12) parallel zur Montageebene (5) ausgerichtet ist.

4. Schaltschrank oder Rack nach Anspruch 2 oder 3,
**dadurch gekennzeichnet,**
**dass** die Begrenzungswand (13) rechtwinklig in den Befestigungsabschnitt (11) übergeht.

5. Schaltschrank oder Rack nach einem der Ansprüche 2 bis 4,
**dadurch gekennzeichnet,**
**dass** der Anlageabschnitt (12) rechtwinklig in einen bezüglich der Montageebene (5) nach hinten gerichteten Seitenwandabschnitt (15) übergeht oder rechtwinklig in eine nach vorn zur Montageebene (5) gerichteten und höchstens bis in diese vorstehende außenseitige Begrenzungswand der Aufnahme (14) übergeht.

6. Schaltschrank oder Rack nach einem der Ansprüche 2 bis 5,
**dadurch gekennzeichnet,**
**dass** in dem Anlageabschnitt (12) eine Haltelochreihe (12.1) mit in regelmäßigem Rasterabstand angeordneten Haltelöchern (12.2) angeordnet ist.

7. Schaltschrank oder Rack nach Anspruch 6,
**dadurch gekennzeichnet,**
**dass** die Haltelöcher (12.2) quadratisch oder rechteckförmig mit in Längsrichtung des Montageprofils (10) verlaufenden Längsseiten ausgebildet sind und dass die Antennenleiste (30) auf ihrer dem Anlageabschnitt (12) zugekehrten Rückseite mit Haltehaken (33) versehen ist, die auf den Abstand der Haltelöcher (12.2) oder ein Vielfaches davon abgestimmt sind und vertikale Hakenabschnitte aufweisen, die eine geringere Länge besitzen als die lichte Öffnungsweite der Haltelöcher (12.2) in vertikaler Richtung und die soweit von der rückseitigen Außenfläche der Antennenleiste (30) beabstandet sind, dass sie einen die Haltelöcher (12.2) umgebenden Wandbereich des Anlageabschnitts (12) mit einer Klemmkraft hintergreifen.

8. Schaltschrank oder Rack nach einem der vorhergehenden Ansprüche,
**dadurch gekennzeichnet,**
**dass** die Antennenleiste (30) quadratischen oder rechteckförmigen Querschnitt besitzt und bezüglich der eingebauten Lage auf ihrer Frontseite mit einem daran fest oder abnehmbar fixierten Abdeckteil (32) versehen ist.

9. Schaltschrank oder Rack nach Anspruch 8,
**dadurch gekennzeichnet,**
**dass** das Abdeckteil (32) zumindest abschnittsweise transparent ausgebildet ist und
**dass** im Inneren der Antennenleiste (30) Leuchtelemente (31) angeordnet sind, die in Längsrichtung der Antennenleiste (30) in gleichmäßigem Rasterabstand im Raster einer Höheneinheit HE oder einem ganzzahligen Vielfachen oder gleichmäßigen Teilabstand davon angeordnet, getrennt ansteuerbar und im Leuchtzustand durch das transparente Abdeckteil (30) positionsgenau sichtbar sind.

10. Schaltschrank oder Rack nach einem der vorhergehenden Ansprüche,
**dadurch gekennzeichnet,**
**dass** im Inneren der Antennenleiste (30) im Raster einer Höheneinheit HE oder einem ganzzahligen Vielfachen oder gleichmäßigen Teilabstand davon in Längsrichtung der Antenneneinheit (30) voneinander beabstandete Antennenelemente angeordnet sind.

11. Schaltschrank oder Rack nach einem der vorhergehenden Ansprüche,
**dadurch gekennzeichnet,**
**dass** in den Befestigungsabschnitten (11) Lochreihen (11.1) mit in vertikaler Richtung im Rasterabstand einer Höheneinheit HE oder einem gleichmäßigen Teilabstand davon beabstandeten Befestigungslöchern (11.2) angeordnet sind,
**dass** in den Montageabschnitten (21) der Einbaueinheiten (20) auf den Abstand der Löcher oder ein ganzzahliges Vielfaches davon abgestimmte Montagelöcher (21.1) angeordnet sind und
**dass** in den Befestigungsabschnitten (42) der Halteelemente (40) auf die Montagelöcher (21.1) abgestimmte Öffnungen (43) angeordnet sind, wobei der Abstand von der Mitte der Befestigungslöcher (11.2) bis zum außenseitigen Rand der Antennenleiste (30) so groß ist wie die Ausdehnung der Halteelemente (40) von der Mitte der Öffnungen (43) zum äußeren Rand des Trageabschnitts (41).

12. Schaltschrank oder Rack nach einem der vorhergehenden Ansprüche,
**dadurch gekennzeichnet,**
**dass** die vertikalen Montageprofile (10, 10') sich zwischen einem oberen und unteren horizontalen Montageschenkel oder Rahmenschenkel (2, 3) des Schaltschranks oder Racks erstrecken und
**dass** in Verlängerung der Antennenleiste (30) in ihrer Einbaulage in dem oberen und/oder unteren horizontalen Montageschenkel oder Rahmenschenkel (2, 3) eine Ausdehnung (4, 4') eingebracht ist, die größer ist als der Querschnitt der Antennenleiste (30).

## Claims

1. A switchgear cabinet or rack comprising a mounting unit, the front of which has vertical mounting profiles (10, 10') that laterally delimit an installation space (6) for installed user-side units (20), said profiles having flat fixing sections (11) that lie on a front mounting plane (5) and that are used to fix laterally projecting mounting sections (21) of said installed units (20) and comprising components of a detection device for determining whether or not an installed unit (20) is present in an installation position of the installation space (6), said components of the detection device having a vertical antenna strip (30) that is attached to a mounting profile (10, 10'), namely abutting to an abutment section of the mounting profile (10, 10') with its rear side, and contains antenna elements arranged therein and code carriers that are designed as transponder elements (44) and are provided on said installed units (20), **characterized in that** the front face of said antenna strip (30) lies on the mounting plane (5) or is set back by a maximum of 10 mm in relation to said plane and that the relevant transponder element (44) is provided in front of the front face of said antenna strip (30) and fixed to a support section (41) of a retaining element (40) that overlaps the antenna strip (30), said retaining element (40) being attached to the neighboring mounting section (21) of associated installed unit (20) by a connection section (42).

2. The switchgear cabinet or rack of claim 1, **characterized in that** said mounting profile (10) comprises a cavity (14) which is at least partly adapted to the cross section of said antenna strip (30), comprising an abutment section (12) which is set back in relation to the mounting plane (5) at least by the cross section depth of said antenna strip (30) and an inner boundary wall (13) delimiting said cavity (14) on its face facing said installation space (6).

3. The switchgear cabinet or rack of claim 2, **characterized in that** said abutment section (12) and said inner boundary wall (13) are arranged perpendicularly in cross section of said cavity (14), wherein said abutment section (12) is aligned parallel to said mounting plane (5).

4. The switchgear cabinet or rack of claim 2 or 3, **characterized in that** said boundary wall (13) merges perpendicularly into said fixing section (11).

5. The switchgear cabinet or rack of any of claims 2 to 4, **characterized in that** said abutment section (12) merges perpendicularly into a lateral wall section (15) oriented rearwardly in relation to said mounting plane (5) or merges perpendicularly into an outer boundary wall of said cavity (14) oriented forwardly to said mounting plane (5) and at most protrudes into it.

6. The switchgear cabinet or rack of any of claims 2 to 5, **characterized in that** a row (12.1) of retaining holes with retaining holes (12.2) arranged in regular grid spacing is arranged in said abutment section (12).

7. The switchgear cabinet or rack of claim 6, **characterized in that** said retaining holes (12.2) are square or rectangular with longitudinal sides running in longitudinal direction of said mounting profile (10) and that said antenna strip (30) is provided with retaining hooks (33) on its rear facing to said abutment section (12) which are harmonized with the spacing of said retaining holes (12.2) or a multiple thereof and comprise vertical hooked sections which possess a smaller length than the clear opening width of said retaining holes (12.2) in vertical direction and which are spaced from the rearward outer face of said antenna strip (30) so that they engage behind a wall section of the abutment section (12) surrounding the retaining holes (12.2) with a clamping force.

8. The switchgear cabinet or rack of any of the preceding claims, **characterized in that** said antenna strip (30) has square or rectangular cross section and is provided with a cover part (32) fixed or removably attached on its front face in relation to the installed position.

9. The switchgear cabinet or rack of claim 8, wherein said cover part (32) is at least in sections transparent and that inside said antenna strip (30) illuminating element (31) are disposed which in longitudinal direction of said antenna strip (30) are arranged in regular grid spacing within grid of a unit of height HE or an integer multiple thereof or in regular partial spacing thereof, are individually controllable and are in an illuminating state accurately visible through said transparent cover part (32).

10. The switchgear cabinet or rack of any of the preceding claims, **characterized in that** spaced antenna elements are arranged in said antenna strip (30) within grid of a unit of height HE or an integer multiple thereof or regular partial spacing thereof in longitudinal direction of said antenna unit (30).

11. The switch gear cabinet or rack of any of the preceding claims, **characterized in that** rows (11.1) of holes are arranged in said fixing sections (11) which comprise fixing holes (11.2) spaced within grid of a unit of height HE or a regular partial spacing in a vertical direction, that mounting holes (21.1) are arranged in said mounting sections (21) of said installed units (20) which are harmonized with the spacing of the holes or an integer multiple thereof, and that openings (43) harmonized with the mounting holes (21.1) are arranged in the fixing sections (42) of the retaining elements (40), wherein the spacing from the center of fixing holes (11.2) to the outer edge of said antenna strip (30) is equal to the dimension of the retaining elements (40) from the center of openings (43) to the outer edge of said support section (41).

12. The switchgear cabinet or rack of any of the preceding claims, **characterized in that** said vertical mounting profiles (10, 10') extend between an upper and a lower horizontal mounting leg or frame leg (2, 3) of the switchgear cabinet or rack and that in extension of said antenna strip (30) in its installation position, an extension (4, 4') is formed in said upper and/or lower mounting leg or frame leg (2, 3) which is larger than the cross section of said antenna strip (30).

## Revendications

1. Armoire de commande ou baie, comportant un dispositif de montage, qui comporte des profilés de montage (10, 10') verticaux, qui délimitent latéralement du côté frontal un espace d'encastrement (6) pour des unités d'encastrement (20) du côté utilisateur et qui sont munis de parties de fixation (11) plates, situées dans un plan de montage (5) frontal, pour y fixer des parties de montage (21) latéralement saillantes des unités d'encastrement (20), et comportant des composants d'un dispositif de détection permettant de constater si une unité d'encastrement (20) est présente ou non au niveau d'une position de montage de l'espace d'encastrement (6), lesdits composants du dispositif de détection comportant une baguette d'antenne (30) verticale attachée à un profilé de montage (20), laquelle est amenée en appui avec sa face arrière sur une partie d'appui du profilé de montage (10, 10') et dans laquelle sont disposés des éléments d'antenne, et des supports de code réalisés sous forme d'éléments de transpondeur (44) disposés au niveau des unités d'encastrement (20),
**caractérisée en ce que** la baguette d'antenne (30) est disposée avec sa face frontale dans le plan de montage (5) ou est disposée en retrait de celui-ci sur 10 mm maximum, et **en ce que** l'élément de transpondeur (44) respectif est disposé devant la face frontale de la baguette d'antenne (30) et est fixé sur une partie de support (41), recouvrant la baguette d'antenne (30), d'un élément de retenue (40) qui est attaché avec une partie d'assemblage (42) sur une partie de montage (21) adjacente de l'unité d'encastrement (20) associée.

2. Armoire de commande ou baie selon la revendication 1, **caractérisée en ce que** le profilé de montage (10) comporte un logement (14), qui est adapté au moins partiellement à la section transversale de la baguette d'antenne (30), est muni d'une partie d'appui (12), située en retrait du plan de montage (5) au moins sur la profondeur de la section transversale de la baguette d'antenne (30), et est muni d'une paroi de délimitation (13) intérieure délimitant le logement (14) sur sa face orientée vers l'espace d'encastrement (6).

3. Armoire de commande ou baie selon la revendication 2, **caractérisée en ce que** la partie d'appui (12) et la paroi de délimitation (13) intérieure sont disposées perpendiculairement entre elles dans la section transversale du logement (14), ladite partie d'appui (12) étant orientée parallèlement au plan de montage (5).

4. Armoire de commande ou baie selon la revendication 2 ou 3, **caractérisée en ce que** la paroi de délimitation (13) se prolonge perpendiculairement dans la partie de fixation (11).

5. Armoire de commande ou baie selon l'une quelconque des revendications 2 à 4, **caractérisée en ce que** la partie d'appui (12) se prolonge perpendiculairement dans une partie de paroi latérale (15) orientée vers l'arrière par rapport au plan de montage (5) ou se prolonge perpendiculairement dans une paroi de délimitation extérieure du logement (14), laquelle est orientée vers l'avant par rapport au plan de montage (5) et s'avance en saillie au maximum jusque dans celui-ci.

6. Armoire de commande ou baie selon l'une quelconque des revendications 2 à 5, **caractérisée en ce que** dans la partie d'appui (12) est disposée une rangée de trous de retenue (12.1) avec des trous de retenue (12.2) disposés à des intervalles de pas réguliers.

7. Armoire de commande ou baie selon la revendication 6, **caractérisée**
**en ce que** les trous de retenue (12.2) sont carrés ou rectangulaires avec des côtés longitudinaux s'étendant dans le sens longitudinal du profilé de montage (10), et
**en ce que** la baguette d'antenne (30), sur sa face arrière orientée vers la partie d'appui (12), est munie de crochets de fixation (33) qui sont ajustés à la distance entre les trous de retenue (12.2) ou à un multiple de celle-ci et comportent des parties de crochet verticales qui ont une longueur inférieure à la largeur d'ouverture intérieure des trous de retenue (12.2) dans le sens vertical et qui sont écartés de la face extérieure arrière de la baguette d'antenne (30) à une distance telle qu'ils saisissent par l'arrière avec une force de serrage une zone de paroi, entourant les trous de retenue (12.2), de la partie d'appui (12).

8. Armoire de commande ou baie selon l'une quelconque des revendications précédentes, **caractérisée en ce que** la baguette d'antenne (30) a une section transversale carrée ou rectangulaire et est munie sur sa face frontale, par référence à la position montée, d'une partie de recouvrement (32) fixée à ladite face frontale de manière fixe ou amovible.

9. Armoire de commande ou baie selon la revendication 8, **caractérisée**
**en ce que** la partie de recouvrement (32) est transparente au moins par zones, et
**en ce qu'**à l'intérieur de la baguette d'antenne (30) sont disposés des éléments d'éclairage (31) qui, en étant disposés à des intervalles de pas réguliers dans la trame d'une unité de hauteur HE ou d'un multiple entier ou distance partielle uniforme de celle-ci, peuvent être commandés séparément et, à l'état éclairé, sont visibles dans leur position exacte à travers la partie de recouvrement (30) transparente.

10. Armoire de commande ou baie selon l'une quelconque des revendications précédentes, **caractérisée en ce qu'**à l'intérieur de la baguette d'antenne (30) dans la trame d'une unité de hauteur HE ou d'un multiple entier ou distance partielle uniforme de celle-ci, sont disposés des éléments d'antenne écartés les uns des autres dans le sens longitudinal de la baguette d'antenne (30).

11. Armoire de commande ou baie selon l'une quelconque des revendications précédentes, **caractérisée**
**en ce que** dans les parties de fixation (11) sont disposées des rangées de trous (11.1) avec des trous de fixation (11.2) écartés dans le sens vertical des intervalles de pas d'une unité de hauteur HE ou d'un multiple entier ou distance partielle uniforme de celle-ci,
**en ce que** dans les parties de montage (21) des unités d'encastrement (20) sont disposés des trous de montage (21.1) ajustés à la distance entre les trous ou à un multiple entier de celle-ci, et
**en ce que** dans les parties de fixation (42) des éléments de retenue (40) sont disposés des orifices (43) ajustés aux trous de montage (21.1), la distance entre le milieu des trous de fixation (11.2) et le bord extérieur de la baguette d'antenne (30) étant égale à l'extension des éléments de retenue (40) depuis le milieu des orifices (43) jusqu'au bord extérieur de la partie de support (41).

12. Armoire de commande ou baie selon l'une quelconque des revendications précédentes, **caractérisée**
**en ce que** les profilés de montage (10, 10') verticaux s'étendent entre une branche de montage horizontale supérieure et une branche de montage horizontale inférieure ou les branches (2, 3) du cadre de l'armoire de commande ou baie, et
**en ce que** dans le prolongement de la baguette d'antenne (30), dans sa position de montage dans la branche de montage horizontale supérieure et/ou la branche de montage horizontale inférieure ou les branches (2, 3) du cadre, est insérée une extension (4, 4') qui est plus grande que la section transversale de la baguette d'antenne (30).
